# EUROPEAN PATENT SPECIFICATION

(11) **EP 3 471 267 B1**
(45) Date of publication and mention of the grant of the patent: **06.01.2021**
(21) Application number: 17196420.8
(22) Date of filing: 13.10.2017
(51) Int. Cl.: H03F 1/32, H03F 3/181, H03G 5/00, G10L 21/0316

(54) **METHOD AND APPARATUS FOR REPAIRING DISTORTION OF AN AUDIO SIGNAL**
VERFAHREN UND VORRICHTUNG ZUR REPARATUR EINER VERZERRUNG EINES AUDIOSIGNALS
PROCÉDÉ ET APPAREIL DE RÉPARATION DE LA DISTORSION D'UN SIGNAL AUDIO

(43) Date of publication of application: 17.04.2019
(73) Proprietor: Vestel Elektronik Sanayi ve Ticaret A.S., 45030 Manisa (TR)
(72) Inventor: SARIARSLAN, Muhammet Kürsat, 45030 Manisa (TR)
(74) Representative: Flint, Adam

(56) References cited:
- GB-A- 2 357 409
- US-A- 3 684 838
- US-A1- 2009 083 031

## Description

### Technical Field

The present disclosure relates to a method and apparatus for processing a distorted audio signal to repair distortion of the distorted audio signal.

### Background

There are many situations in which an audio signal may be distorted, that is, some distortion is present in the audio signal. This may be because for example the original source material was distorted, for example because distortion occurred or was introduced by recording equipment during recording of the original source material. As another example, distortion may have been introduced during some processing of the audio signal following recording of the original source material. As a particular example, clipping occurs when a waveform exceeds a dynamic range of a recording device, an amplifier, etc. Any portions of an audio signal that exceed the dynamic range or saturation level of the recording device or amplifier, etc. are clipped (i.e. removed), causing audible distortion when the clipped recorded audio signal is played.

US3684838A discloses a system and method for transmitting relatively high fidelity audio signals (e.g. speech and music signals having frequencies from about 100 cps to about 3,000 cps or higher) across an audio signal transmission channel characterized by a passband which effectively transmits only a portion of the frequency components making up the audio signals.

GB2357409A discloses an audio signal processing apparatus with a visual display means coupled to a data processor which operates to generate on the display means a visual representation of a filter characteristic response in the form of an amplitude against frequency curve.

### Summary

According to a first aspect disclosed herein, there is provided a method of processing a distorted audio signal to repair distortion of the distorted audio signal, the method comprising:
passing the distorted audio signal through a band-reject filter to output a band-reject filtered signal, the band-reject filter having a band-reject frequency such that the band-reject filtered signal contains no frequency component at the band-reject frequency;
passing the distorted audio signal through a band-pass filter to output a band-pass filtered signal, the band-pass frequency of the band-pass filter being the same as the band-reject frequency of the band-reject filter;
determining with a signal detector whether the distorted audio signal contains a frequency component at the band-pass frequency by detecting the presence of the band-pass filtered signal output by the band-pass filter; and
if the distorted audio signal contains a frequency component at the band-pass frequency, generating with a signal generator a generated audio signal having a frequency that is the same as the band-reject frequency and adding with a summer the generated audio signal to the band-reject filtered signal to obtain a repaired audio signal.

In an example, the method comprises receiving a user input for the level of the generated audio signal to be added to the band-reject filtered signal, wherein the generated audio signal added to the band-reject filtered signal is added at the user-input level to obtain the repaired audio signal.

The level for the generated audio can for example be set freely by the user. The user may for example do this based on listening tests when listening to the repaired audio signal, repeating the repair steps as necessary until the user is happy with the sound of the repaired audio signal. As an alternative, the level for the generated audio can be set automatically.

In an example, the method comprises providing a graphical representation of the distorted audio signal prior to being repaired and a graphical representation of the repaired audio signal, and receiving the user input via a graphical user interface to control the repair of distortion of the audio signal.

In an example, the method comprises:
detecting with the signal detector the level of the band-pass filtered signal output from the band-pass filter.

The level of audio present within the band-pass filtered signal can be used to assist in providing a user with a graphical representation of for example the original audio signal and the repaired audio signal. This in turn can for example assist the user in manually controlling the level of the generated audio that is added to the band-reject filtered signal to obtain the repaired audio signal.

In an example:
passing the distorted audio signal through the band-reject filter comprises passing the distorted audio signal through plural band-reject filters to output the band-reject filtered signal, each band-reject filter having a different band-reject frequency such that the band-reject filtered signal contains no frequency components at the band-reject frequencies;
generating with the signal generator the generated audio signal comprises generating plural audio signals, each generated audio signal having a frequency that is the same as a respective one of the band-reject frequencies; and
adding with the summer the generated audio signal to the band-reject filtered signal comprises adding the plural generated audio signals to the band-reject filtered signal to obtain the repaired audio signal.

The plural band-reject filters may for example be arranged to operate in sequence, each band-reject filter rejecting a different band-reject frequency so that the filtered signal leaving the last band-reject filter is the band-reject filtered signal that is used in the adding step.

In an example, passing the distorted audio signal through the band-pass filter comprises passing the audio signal through plural band-pass filters to output corresponding band-pass filtered signals, the band-pass frequencies of the band-pass filters being respectively the same as the band-reject frequencies of the band-reject filters; and the method comprises:
determining with the signal detector whether the distorted audio signal contains a respective frequency component at each of the band-pass frequencies by detecting the presence of the respective band-pass filtered signal output by the respective band-pass filter;
wherein each generated audio signal having the frequency that is the same as the respective band-reject frequency is only generated if the distorted audio signal contains the respective frequency component at the respective band-pass frequency.

Having plural band-reject filters and, correspondingly, plural band-pass filters and signal generators, enables the method to be carried out more quickly because a number of different frequencies can be analysed and corrected substantially simultaneously.

As one alternative, there may for example be a single signal generator which is controllable so that the frequency of the generated signal can be varied as needed. In that case, once one audio signal is generated at a certain frequency, that audio signal can be stored. Then one or more further audio signals of different frequencies can be generated and stored. Ultimately, once all of the necessary audio signals have been generated, they can be added to the band-reject filtered signal to obtain a repaired audio signal.

According to a second aspect disclosed herein, there is provided apparatus for processing a distorted audio signal to repair distortion of the distorted audio signal, the apparatus comprising:
a band-reject filter for receiving the distorted audio signal and outputting a band-reject filtered signal, the band-reject filter having a band-reject frequency such that the band-reject filtered signal contains no frequency component at the band-reject frequency;
a band-pass filter for receiving the distorted audio signal and outputting a band-pass filtered signal, the band-pass frequency of the band-pass filter being the same as the band-reject frequency of the band-reject filter;
a signal detector for determining whether the distorted audio signal contains a frequency component at the band-pass frequency by detecting the presence of the band-pass filtered signal output by the band-pass filter;
a signal generator arranged to generate a generated audio signal having a frequency that is the same as the band-reject frequency if the distorted audio signal contains a frequency component at the band-pass frequency; and
a summer for adding the generated audio signal to the band-reject filtered signal to obtain a repaired audio signal.

In an example, the apparatus comprises an interface for receiving a user input for the level of the generated audio signal to be added to the band-reject filtered signal, the apparatus being arranged such that the generated audio signal added to the band-reject filtered signal is added at the user-input level to obtain the repaired audio signal.

In an example, the apparatus is arranged to output for display a graphical representation of the audio signal prior to being repaired and a graphical representation of the repaired audio signal, and arranged to receive user input via a graphical user interface to control the repair of distortion of the audio signal.

In an example, the apparatus comprises:
the signal level detector being arranged to detect the level of the band-pass filtered signal output from the band-pass filter.

In an example, the apparatus comprises:
plural band-reject filters for receiving the distorted audio signal, each band-reject filter having a different band-reject frequency such that the band-reject filtered signal contains no frequency components at the band-reject frequencies; and
plural signal generators for generating plural audio signals, each generated audio signal having a frequency that is the same as a respective one of the band-reject frequencies;
the summer being arranged to add the plural generated audio signals to the band-reject filtered signal to obtain the repaired audio signal.

In an example, the apparatus comprises:
plural band-pass filters for receiving the distorted audio signal, the band-pass frequencies of the band-pass filters being the same as the band-reject frequencies of respective ones of the band-reject filters to output corresponding band-pass filtered signals; and
the signal detector being arranged to determine whether the distorted audio signal contains a respective frequency component at each of the band pass frequencies by detecting the presence of the respective band-pass filtered signal output by the respective band-pass filter;
the apparatus being arranged such that each generated audio signal having the frequency that is the same as the respective band-reject frequency is only generated if the distorted audio signal contains the respective frequency component at the respective band-pass frequency.

### Brief Description of the Drawings

To assist understanding of the present disclosure and to show how embodiments may be put into effect, reference is made by way of example to the accompanying drawings in which:
Figure 1 shows schematically clipping of a signal at a particular frequency over time;
Figure 2 shows schematically distortion or clipping of a range of frequencies in an audio signal;
Figure 3 shows schematically an example of apparatus for repairing distortion of an audio signal; and
Figure 4 shows schematically the audio signal of Figure 2 after repair.

### Detailed Description

As mentioned, there are many situations in which an audio signal may be distorted. This may be because for example the original source material was distorted, for example because distortion occurred or was introduced by recording equipment during recording of the original source material. As another example, distortion may have been introduced during some processing of the audio signal following recording of the original source material.

As a particular example, clipping occurs when a waveform exceeds a dynamic range of a recording device, an amplifier, etc. Any portions of an audio signal that exceed the dynamic range or saturation level of the recording device or amplifier, etc. are clipped (i.e. removed), causing audible distortion when the clipped recorded audio signal is played.

The distortion or clipping may affect different frequencies within the audio signal differently. For example, there may be particularly loud portions in the source material at certain frequencies which exceed the dynamic range of the recording equipment, leading to distortion or clipping at those frequencies. As another example, the gain in any amplifiers that are used to amplify the audio signal (whether during recording of the source material or during some post-recording production or processing) may not be uniform across all audio frequencies, resulting in some frequencies tending to be clipped and others not.

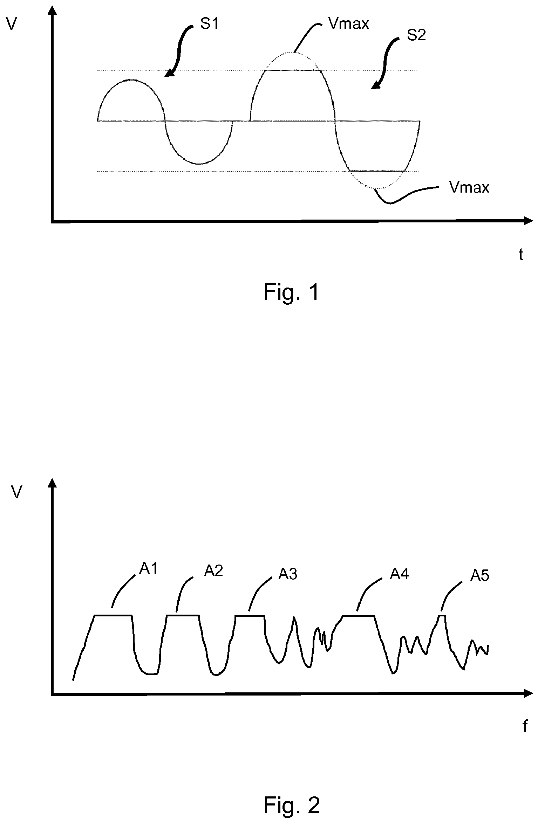

Referring to Figure 1, this shows variation of amplitude V over time for two sine waves S1, S2 at a particular frequency (which therefore represent pure tones at that frequency) which are processed by some equipment (such as a recording apparatus, a microphone, an amplifier, etc., etc.). The dynamic range of the equipment is indicated by dashed horizontal lines. The first sine wave S1 has a maximum amplitude that is within the dynamic range of the relevant equipment and therefore is not clipped. On the other hand, the second sine wave S2 has a maximum amplitude Vmax that exceeds the dynamic range of the relevant equipment. This results in the second sine wave S2 being clipped.

For completeness, it is mentioned that the clipping shown in Figure 1 is so-called "hard clipping", where the signal above the dynamic range is entirely absent, resulting in a flat cut-off. Hard clipping is common in for example equipment that uses transistors, such as transistor amplifiers. On the other hand, with "soft clipping", the amplitude of the signal above some threshold is reduced, but the clipped signal continues to follow the original at a reduced gain even in that region. The aspects described herein may be applied to audio signals that are subject to hard clipping or soft clipping, or indeed other types of distortion.

Figure 2 shows schematically an audio signal that is subject to distortion or clipping. The drawing shows the variation of amplitude with frequency for the audio signal at a particular instant of time. There are a number of regions A1, A2, A3, A4, A5 that are subject to clipping. These clipped regions A1, A2, A3, A4, A5 may be a single frequency or may cover a range of frequencies.

In examples described herein, the clipped or otherwise distorted audio signal is passed through a band-reject filter to obtain a band-reject filtered signal, the band-reject filtered signal containing no frequency component at the band-reject frequency of the band-reject filter. In addition, audio having a frequency that is the same as the band-reject frequency is generated. The generated audio is added to the band-reject filtered signal to obtain a repaired audio signal.

This can result in a repaired audio signal that is closer to the intended original audio signal (i.e. the audio signal prior to being distorted or clipped). This can also avoid the use of tone controls (bass, mid and treble) or equaliser circuits or the like, which are used to try to overcome or mask distortion, but often introduce their own artefacts, such as affecting other frequencies. (Nevertheless, the user may still apply an equaliser circuit or tone controls to the repaired signal, especially during playback, possibly to overcome local environmental factors, as is common with equaliser circuits and the like.)

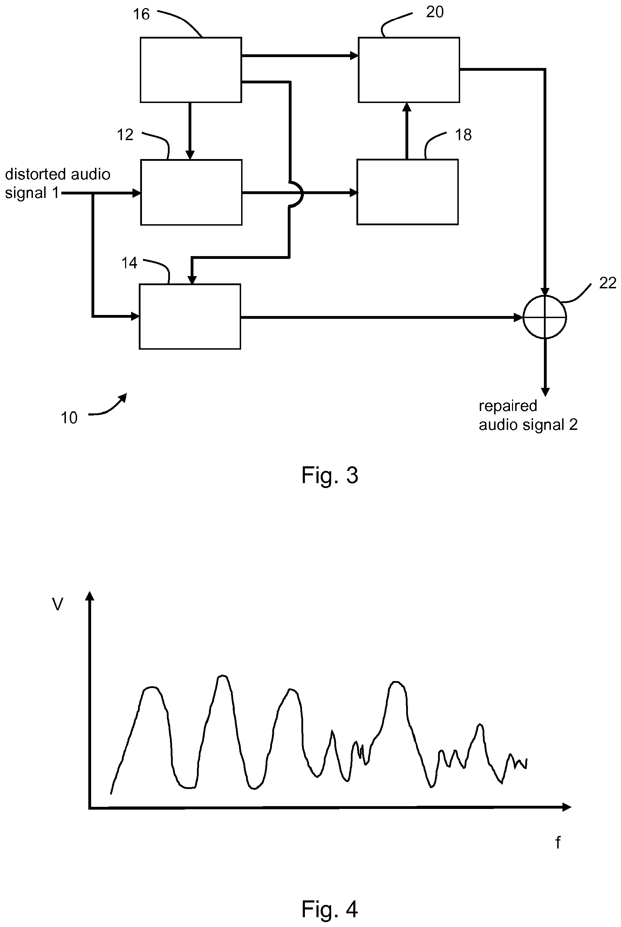

Referring now to Figure 3, this shows schematically an example of apparatus 10 for repairing distortion of an audio signal 1. One or more of the blocks indicated schematically in Figure 3 may be implemented in hardware or software or a combination of hardware and software. Some specific examples of this will be given below.

The distorted audio signal 1 is passed to a band-pass filter 12. The band-pass filter 12 has a band-pass frequency, and so filters the distorted audio signal 1 so that only components of the distorted audio signal 1 at the band-pass frequency are output by the band-pass filter 12.

The distorted audio signal 1 is also passed to a band-reject filter 14. The band-reject filter 14 has a band-reject frequency, and so filters the distorted audio signal 1 so that components of the distorted audio signal 1 at the band-reject frequency are rejected and not output by the band-reject filter 14. In this example, the band-reject frequency of the band-reject filter 14 is the same as the band-pass frequency of the band-pass filter 12. As a result, the output of the band-reject filter 14 is the distorted audio signal but without the frequency component that is passed by the band-pass filter 12.

In this example, the apparatus 10 has a frequency selector 16 which is in communication with both the band-pass filter 12 and the band-reject filter 14. The frequency selector 16 operates to set the band-pass frequency of the band-pass filter 12 and the band-reject frequency of the band-reject filter 14. Again, in this example, the band-pass frequency and the band-reject frequency are controlled to be the same.

The output of the band-pass filter 12 is passed to a signal detector 18 of the apparatus 10. The signal detector 18 operates to detect the presence of a signal output by the band-pass filter 12. That is, the signal detector 18 operates to determine whether the distorted audio signal 1 has a frequency component at the band-pass frequency of the band-pass filter 12. In this example, if the signal detector 18 detects the presence of a signal output by the band-pass filter 12, then the signal detector 18 also detects the level or amplitude of the signal output by the band-pass filter 12.

The apparatus 10 further has a signal generator 20. The signal generator 20 is operable to generate an audio signal. The signal generator 20 is also in communication with the frequency selector 16. The frequency selector 16 is operable to control the frequency of the audio signal generated by the signal generator 20. In this example, the frequency of the audio signal generated by the signal generator 20 is controlled to be the same as the band-pass frequency of the band-pass filter 12 and the band-reject frequency of the band-reject filter 14. The signal generator 20 is also in communication with the signal detector 18 to receive outputs from the signal detector 18, which control the signal generator 20 as will be discussed.

Finally for the apparatus 10, the apparatus 10 further has a summer 22, which is connected to receive the output of the band-reject filter 14 and the output of the signal generator 20, to add those outputs, and thereby to output the repaired audio signal 2.

In use, the distorted audio signal 1 is passed to the band-pass filter 12 and the band-reject filter 14. The band-pass frequency of the band-pass filter 12 and the band-reject frequency of the band-reject filter 14 are set to be the same by the frequency selector 16. The signal detector 18 determines from the output of the band-pass filter 12 whether or not the distorted audio signal 1 contained any audio at that frequency. If there was audio at the frequency in the distorted audio signal 1 (i.e. the level or amplitude of the signal output by the band-pass filter 12 is not zero), then the signal detector 18 outputs a command or other signal to the signal generator 20, causing the signal generator 20 to generate an audio signal at the frequency. Then the newly generated audio signal at the frequency is added to the output of the band-reject filter 14 by the summer 22, which therefore outputs the repaired audio signal 2. That is, the repaired audio signal 2 is in effect the original distorted audio signal 1 from which a certain frequency has been removed and to which a regenerated signal at that frequency has been added. Where the distorted audio signal 1 has been subject to clipping, the regenerated signal will usually have an amplitude or level that is greater than the level of the corresponding frequency component that has been removed.

This results in a repaired audio signal that is closer to the intended original audio signal (i.e. the audio signal prior to being distorted or clipped). It also obviates the use of equaliser circuits or the like, which can often add unwanted frequencies or distort other frequencies (which is often termed "colouring" or the like).

In the above, it is mentioned that the frequency selector 16 controls the band-pass frequency of the band-pass filter 12 and the band-reject frequency of the band-reject filter 14. In one example, the frequency selector 16 can be used to cause the band-pass filter 12 and the band-reject filter 14 to operate over a number of frequencies in turn. Correspondingly, the signal generator 20 can generate audio signals at those frequencies in turn. The outputs of the band-reject filter 14 and the corresponding outputs of the signal generator 20 at the different frequencies can be stored in buffers or memory circuits until all desired frequencies have been analysed. Then the various outputs can be summed to produce a repaired audio signal 2 in which a number of frequencies have been repaired.

This is illustrated in Figure 4. This shows a repaired version of the distorted audio signal of Figure 2. Each of the regions A1, A2, A3, A4, A5 that was subject to clipping in the distorted audio signal has been repaired.

Alternatively or additionally, there may be plural band-pass filters 12 which operate at different frequencies. Similarly, alternatively or additionally, there may be plural band-reject filters 14 which operate at different frequencies. In either case, none, some or all of the plural band-pass filters 12 and band-reject filters 14 may be controllable so that their band-pass or band-reject frequencies may be varied. Similarly, alternatively or additionally, there may be plural signal generators 20, which operate at different frequencies. None, some or all of the plural signal generators 20 may be controllable so that the frequency of the generated signal can be varied. In any event, having plural band-pass filters 12 and/or band-reject filters 14 and/or plural signal generators 20 enables quicker processing of the audio signal as plural frequencies can be analysed and regenerated by the signal generators 20 if need be.

The or each band-pass filter 12 may have a centre band-pass frequency and a frequency bandwidth such that the or each band-pass filtered signal contains a number of frequency components across the frequency bandwidth of the band-pass filter 12. Similarly, the or each band-reject filter 14 may have a centre band-pass frequency and a frequency bandwidth such that the or each band-reject filtered signal contains no frequency components within the frequency bandwidth. The generation of audio signals by the or each signal generator 20 for the repair may in particular take into account the nature of the spread of the frequency bandwidth in the filters 12, 14, such that the generated audio has a similar spread of frequencies, with regard to both the amplitude of the individual frequencies and the range of frequencies. In this regard, the frequency bandwidth of a filter is often characterised by the "Q factor" of the filter. This may be defined in this case as for example Q = f_{c} / Δf, where f_{c} is the centre frequency of the filter and Δf is the full bandwidth at half maximum. The or each signal generator may operate to generate signals having frequencies with the same or a similar Q factor.

The user may be provided with a display, for example on a display device of or associated with some computing device, to assist the user in implementing the process to repair the distorted audio signal 1. As a particular example, the user may be provided with a display that shows the distorted audio signal 1, similar to the trace shown in Figure 2. The display may be provided with icons in the form of sliders which enable the user to control the frequencies that are analysed and the level of any audio signal generated by the signal generator 20 at the frequencies. As a specific example, the user may be able to interact with a display that is displaying a trace like that of Figure 2, to highlight a frequency or range of frequencies that are to be analysed and then to raise or lower the slider on the graphical user interface to set the level of the audio signal generated by the signal generator 20 for that frequency or range of frequencies. In some examples, this can be done in real time, so that the user can listen to the repaired audio signal 2 and adjust the frequencies that are analysed and the level of the frequencies that are generated by the signal generator until the user is satisfied with the sound of the repaired audio signal 2.

As an alternative to the user setting the level of the audio signal(s) generated by the signal generator 20 manually, or for example as a default prior to the user adjusting the level manually, the level of the audio signal(s) generated by the signal generator 20 may be set automatically. A number of options for this are possible. In one simple case, the level of the audio signal(s) generated by the signal generator 20 may be set to be a certain proportion above the level or amplitude of the signal output by the band-pass filter 12 as detected by the signal detector 18 (which corresponds to the level of the clipped signal in this example). For example, the level of the generated signal may be set to be say 10% or 20% above the level or amplitude of the signal output by the band-pass filter 12. As a specific example, if the level of the clipped signal is measured to be 2mV, then the level of the generated signal may be set to be 2.5mV. Other options are possible, including for example using a computer-implemented analysis of the nature of the waveform of the original distorted audio signal 1 to attempt to mimic the original undistorted audio signal.

As mentioned, one or more of the blocks indicated schematically in Figure 3 may be implemented in hardware or software or a combination of hardware and software. For example, all of the blocks may be implemented entirely digitally, with appropriate software. Alternatively, some or all of the blocks may be implemented with devices and circuit components. For example, the signal generator(s) may be voltage-controlled oscillators.

The apparatus 1 may be provided as a standalone apparatus or may be incorporated in some other audio apparatus. Such other audio apparatus may be for example an audio playback device, including for example a home theatre system, a television set, a music player, an audio recorder, a computer device, including for example a personal computer, a laptop or tablet computer, etc., a mobile device, including for example a smart phone, etc.

It will be understood that at least some of the processing described herein may be carried out by a processor or processing system or circuitry. Such processor or processing system or circuitry may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors, a digital signal processor or processors, baseband circuitry and radio frequency circuitry, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

Although at least some aspects of the embodiments described herein with reference to the drawings comprise computer processes performed in processing systems or processors, the invention also extends to computer programs, particularly computer programs on or in a carrier, adapted for putting the invention into practice. The program may be in the form of non-transitory source code, object code, a code intermediate source and object code such as in partially compiled form, or in any other non-transitory form suitable for use in the implementation of processes according to the invention. The carrier may be any entity or device capable of carrying the program. For example, the carrier may comprise a storage medium, such as a solid-state drive (SSD) or other semiconductor-based RAM; a ROM, for example a CD ROM or a semiconductor ROM; a magnetic recording medium, for example a floppy disk or hard disk; optical memory devices in general; etc.

The examples described herein are to be understood as illustrative examples of embodiments of the invention. Further embodiments and examples are envisaged.

Furthermore, modifications not described herein may also be employed within the scope of the invention, which is defined in the claims.

## Claims

1. A method of processing a distorted audio signal (1) to repair distortion of the distorted audio signal (1), the method comprising:
passing the distorted audio signal (1) through a band-reject filter (14) to output a band-reject filtered signal, the band-reject filter (14) having a band-reject frequency such that the band-reject filtered signal contains no frequency component at the band-reject frequency;
passing the distorted audio signal (1) through a band-pass filter (12) to output a band-pass filtered signal, the band-pass frequency of the band-pass filter (12) being the same as the band-reject frequency of the band-reject filter (14);
determining with a signal detector (18) whether the distorted audio signal (1) contains a frequency component at the band-pass frequency by detecting the presence of the band-pass filtered signal output by the band-pass filter (12); and
if the distorted audio signal (1) contains a frequency component at the band-pass frequency, generating with a signal generator (20) a generated audio signal having a frequency that is the same as the band-reject frequency and adding with a summer (22) the generated audio signal to the band-reject filtered signal to obtain a repaired audio signal (2).

2. A method according to claim 1, comprising receiving a user input for the level of the generated audio signal to be added to the band-reject filtered signal, wherein the generated audio signal added to the band-reject filtered signal is added at the user-input level to obtain the repaired audio signal (2).

3. A method according to claim 2, comprising providing a graphical representation of the distorted audio signal (1) prior to being repaired and a graphical representation of the repaired audio signal (2), and receiving the user input via a graphical user interface to control the repair of distortion of the audio signal (1).

4. A method according to any of claims 1 to 3, comprising:
detecting with the signal detector (18) the level of the band-pass filtered signal output from the band-pass filter (12).

5. A method according to any of claims 1 to 4, wherein:
passing the distorted audio signal (1) through the band-reject filter (14) comprises passing the distorted audio signal (1) through plural band-reject filters (14) to output the band-reject filtered signal, each band-reject filter (14) having a different band-reject frequency such that the band-reject filtered signal contains no frequency components at the band-reject frequencies;
generating with the signal generator (20) the generated audio signal comprises generating plural audio signals, each generated audio signal having a frequency that is the same as a respective one of the band-reject frequencies; and
adding with the summer (22) the generated audio signal to the band-reject filtered signal comprises adding the plural generated audio signals to the band-reject filtered signal to obtain the repaired audio signal (2).

6. A method according to claim 5, wherein passing the distorted audio signal (1) through the band-pass filter (12) comprises passing the audio signal (1) through plural band-pass filters (12) to output corresponding band-pass filtered signals, the band-pass frequencies of the band-pass filters (12) being respectively the same as the band-reject frequencies of the band-reject filters (14); and comprising:
determining with the signal detector (18) whether the distorted audio signal (1) contains a respective frequency component at each of the band-pass frequencies by detecting the presence of the respective band-pass filtered signal output by the respective band-pass filter (12);
wherein each generated audio signal having the frequency that is the same as the respective band-reject frequency is only generated if the distorted audio signal (1) contains the respective frequency component at the respective band-pass frequency.

7. Apparatus (10) for processing a distorted audio signal (1) to repair distortion of the distorted audio signal (1), the apparatus (10) comprising:
a band-reject filter (14) for receiving the distorted audio signal (1) and outputting a band-reject filtered signal, the band-reject filter (14) having a band-reject frequency such that the band-reject filtered signal contains no frequency component at the band-reject frequency;
a band-pass filter (12) for receiving the distorted audio signal (1) and outputting a band-pass filtered signal, the band-pass frequency of the band-pass filter being the same as the band-reject frequency of the band-reject filter (14);
a signal detector (18) for determining whether the distorted audio signal (1) contains a frequency component at the band-pass frequency by detecting the presence of the band-pass filtered signal output by the band-pass filter (12);
a signal generator (20) arranged to generate a generated audio signal having a frequency that is the same as the band-reject frequency if the distorted audio signal (1) contains a frequency component at the band-pass frequency; and
a summer (22) for adding the generated audio signal to the band-reject filtered signal to obtain a repaired audio signal (2).

8. Apparatus (10) according to claim 7, comprising an interface for receiving a user input for the level of the generated audio signal to be added to the band-reject filtered signal, the apparatus (10) being arranged such that the generated audio signal added to the band-reject filtered signal is added at the user-input level to obtain the repaired audio signal (2).

9. Apparatus (10) according to claim 8, arranged to output for display a graphical representation of the audio signal (1) prior to being repaired and a graphical representation of the repaired audio signal (2), and arranged to receive user input via a graphical user interface to control the repair of distortion of the audio signal (1).

10. Apparatus (10) according to any of claims 7 to 9, comprising:
the signal detector (18) being arranged to detect the level of band-pass filtered signal output from the band-pass filter (12).

11. Apparatus (10) according to any of claims 7 to 10, comprising:
plural band-reject filters (14) for receiving the distorted audio signal (1), each band-reject filter (14) having a different band-reject frequency such that the band-reject filtered signal contains no frequency components at the band-reject frequencies; and
plural signal generators (20) for generating plural audio signals, each generated audio signal having a frequency that is the same as a respective one of the band-reject frequencies;
the summer (22) being arranged to add the plural generated audio signals to the band-reject filtered signal to obtain the repaired audio signal (2).

12. Apparatus (10) according to claim 11, comprising:
plural band-pass filters (12) for receiving the distorted audio signal (1), the band-pass frequencies of the band-pass filters (12) being the same as the band-reject frequencies of respective ones of the band-reject filters (14) to output corresponding band-pass filtered signals; and
the signal detector (18) being arranged to determine whether the distorted audio signal (1) contains a respective frequency component at each of the band pass frequencies by detecting the presence of the respective band-pass filtered signal output by the respective band-pass filter (12);
the apparatus (10) being arranged such that each generated audio signal having the frequency that is the same as the respective band-reject frequency is only generated if the distorted audio signal contains the respective frequency component at the respective band-pass frequency.

## Patentansprüche

1. Verfahren zum Verarbeiten eines verzerrten Audiosignals (1) zum Reparieren einer Verzerrung des verzerrten Audiosignals (1), wobei das Verfahren aufweist:
Leiten des verzerrten Audiosignals (1) durch ein Bandsperrfilter (14), um ein bandsperrgefiltertes Signal auszugeben, wobei das Bandsperrfilter (14) eine Bandsperrfrequenz aufweist, sodass das bandsperrgefilterte Signal keine Frequenzkomponente bei der Bandsperrfrequenz enthält;
Leiten des verzerrten Audiosignals (1) durch ein Bandpassfilter (12), um ein bandpassgefiltertes Signal auszugeben, wobei die Bandpassfrequenz des Bandpassfilters (12) die gleiche wie die Bandsperrfrequenz des Bandsperrfilters (14) ist;
Ermitteln, ob das verzerrte Audiosignal (1) eine Frequenzkomponente bei der Bandpassfrequenz enthält, mit einem Signaldetektor (18) durch Erfassen des Vorhandenseins des vom Bandpassfilter (12) ausgegebenen bandpassgefilterten Signals; und
falls das verzerrte Audiosignal (1) eine Frequenzkomponente bei der Bandpassfrequenz enthält, Generieren eines generierten Audiosignals mit einer Frequenz, die die gleiche wie die Bandsperrfrequenz ist, mit einem Signalgenerator (20) und Hinzufügen des generierten Audiosignals zum bandsperrgefilterten Signal mit einem Addierer (22), um ein repariertes Audiosignal (2) zu erhalten.

2. Verfahren nach Anspruch 1, aufweisend ein Empfangen einer Benutzereingabe für den Pegel des generierten Audiosignals, das dem bandsperrgefilterten Signal hinzugefügt werden soll, wobei das generierte Audiosignal, das dem bandsperrgefilterten Signal hinzugefügt wird, auf dem Benutzereingabepegel hinzugefügt wird, um das reparierte Audiosignal (2) zu erhalten.

3. Verfahren nach Anspruch 2, aufweisend ein Schaffen einer grafischen Darstellung des verzerrten Audiosignals (1), bevor es repariert wird, und einer grafischen Darstellung des reparierten Audiosignals (2) und ein Empfangen der Benutzereingabe über eine grafische Benutzerschnittstelle, um die Reparatur der Verzerrung des Audiosignals (1) zu steuern.

4. Verfahren nach einem der Ansprüche 1 bis 3, aufweisend:
Erfassen des Pegels des vom Bandpassfilter (12) ausgegebenen bandpassgefilterten Signals mit dem Signaldetektor (18).

5. Verfahren nach einem der Ansprüche 1 bis 4, bei welchem
das Leiten des verzerrten Audiosignals (1) durch das Bandsperrfilter (14) ein Leiten des verzerrten Audiosignals (1) durch mehrere Bandsperrfilter (14) aufweist, um das bandsperrgefilterte Signal auszugeben, wobei jedes Bandsperrfilter (14) eine andere Bandsperrfrequenz aufweist, sodass das bandsperrgefilterte Signal keine Frequenzkomponenten bei den Bandsperrfrequenzen enthält;
das Generieren des generierten Audiosignals mit dem Signalgenerator (20) ein Generieren mehrerer Audiosignale aufweist, wobei jedes generierte Audiosignal eine Frequenz hat, die die gleiche wie eine jeweilige der Bandsperrfrequenzen ist; und
das Hinzufügen des generierten Audiosignals zum bandsperrgefilterten Signal mit dem Addierer (22) ein Hinzufügen der mehreren generierten Audiosignale zum bandsperrgefilterten Signal aufweist, um das reparierte Audiosignal (2) zu erhalten.

6. Verfahren nach Anspruch 5, bei welchem das Leiten des verzerrten Audiosignals (1) durch das Bandpassfilter (12) ein Leiten des Audiosignals (1) durch mehrere Bandpassfilter (12) aufweist, um entsprechende bandpassgefilterte Signale auszugeben, wobei die Bandpassfrequenzen der Bandpassfilter (12) jeweils die gleichen sind wie die Bandsperrfrequenzen der Bandsperrfilter (14); und aufweisend:
ein Ermitteln, ob das verzerrte Audiosignal (1) eine jeweilige Frequenzkomponente bei jeder der Bandpassfrequenzen enthält, mit dem Signaldetektor (18) durch Erfassen des Vorhandenseins des jeweiligen bandpassgefilterten Signals, das vom jeweiligen Bandpassfilter (12) ausgegeben wurde,
wobei jedes generierte Audiosignal mit der Frequenz, die die gleiche ist wie die jeweilige Bandsperrfrequenz, nur generiert wird, wenn das verzerrte Audiosignal (1) die jeweilige Frequenzkomponente bei der jeweiligen Bandpassfrequenz enthält.

7. Vorrichtung (10) zum Verarbeiten eines verzerrten Audiosignals (1) zum Reparieren einer Verzerrung des verzerrten Audiosignals (1), wobei die Vorrichtung (10) aufweist:
ein Bandsperrfilter (14) zum Empfangen des verzerrten Audiosignals (1) und Ausgeben eines bandsperrgefilterten Signals auszugeben, wobei das Bandsperrfilter (14) eine Bandsperrfrequenz aufweist, sodass das bandsperrgefilterte Signal keine Frequenzkomponente bei der Bandsperrfrequenz enthält;
ein Bandpassfilter (12) zum Empfangen des verzerrten Audiosignals (1) und Ausgeben eines bandpassgefilterten Signals, wobei die Bandpassfrequenz des Bandpassfilters die gleiche wie die Bandsperrfrequenz des Bandsperrfilters (14) ist;
einen Signaldetektor (18) zum Ermitteln, ob das verzerrte Audiosignal (1) eine Frequenzkomponente bei der Bandpassfrequenz enthält, durch Erfassen des Vorhandenseins des vom Bandpassfilter (12) ausgegebenen bandpassgefilterten Signals;
einen Signalgenerator (20), der eingerichtet ist, um ein generiertes Audiosignal mit einer Frequenz, die die gleiche wie die Bandsperrfrequenz ist, zu erzeugen, falls das verzerrte Audiosignal (1) eine Frequenzkomponente bei der Bandpassfrequenz enthält; und
einen Addierer (22) zum Hinzufügen des generierten Audiosignals zum bandsperrgefilterten Signal, um ein repariertes Audiosignal (2) zu erhalten.

8. Vorrichtung (10) nach Anspruch 7, aufweisend eine Schnittstelle zum Empfangen einer Benutzereingabe für den Pegel des generierten Audiosignals, das dem bandsperrgefilterten Signal hinzugefügt werden soll, wobei die Vorrichtung (10) derart eingerichtet ist, dass das generierte Audiosignal, das dem bandsperrgefilterten Signal hinzugefügt wird, auf dem Benutzereingabepegel hinzugefügt wird, um das reparierte Audiosignal (2) zu erhalten.

9. Vorrichtung (10) nach Anspruch 8, die eingerichtet ist, um eine grafische Darstellung des Audiosignals (1), bevor es repariert wird, und eine grafische Darstellung des reparierten Audiosignals (2) zur Anzeige auszugeben, und die eingerichtet ist, um eine Benutzereingabe über eine grafische Benutzerschnittstelle zu empfangen, um die Reparatur der Verzerrung des Audiosignals (1) zu steuern.

10. Vorrichtung (10) nach einem der Ansprüche 7 bis 9, aufweisend:
den Signaldetektor (18), der eingerichtet ist, um den Pegel des vom Bandpassfilter (12) ausgegebenen bandpassgefilterten Signals zu erfassen.

11. Vorrichtung (10) nach einem der Ansprüche 7 bis 10, aufweisend:
mehrere Bandsperrfilter (14) zum Empfangen des verzerrten Audiosignals (1), wobei jedes Bandsperrfilter (14) eine andere Bandsperrfrequenz aufweist, sodass das bandsperrgefilterte Signal keine Frequenzkomponenten bei den Bandsperrfrequenzen enthält; und
mehrere Signalgeneratoren (20) zum Generieren mehrerer Audiosignale, wobei jedes generierte Audiosignal eine Frequenz hat, die die gleiche wie eine jeweilige der Bandsperrfrequenzen ist,
wobei der Addierer (22) eingerichtet ist, um die mehreren generierten Audiosignale dem bandsperrgefilterten Signal hinzuzufügen, um das reparierte Audiosignal (2) zu erhalten.

12. Vorrichtung (10) nach Anspruch 11, aufweisend:
mehrere Bandpassfilter (12) zum Empfangen des verzerrten Audiosignals (1), wobei die Bandpassfrequenzen der Bandpassfilter (12) jeweils die gleichen sind wie die Bandsperrfrequenzen der jeweiligen Bandsperrfilter (14), um entsprechende bandpassgefilterte Signale auszugeben,
wobei der Signaldetektor (18) eingerichtet ist, um durch Erfassen des Vorhandenseins des jeweiligen bandpassgefilterten Signals, das vom jeweiligen Bandpassfilter (12) ausgegeben wurde, zu ermitteln, ob das verzerrte Audiosignal (1) eine jeweilige Frequenzkomponente bei jeder der Bandpassfrequenzen enthält,
wobei die Vorrichtung (10) derart eingerichtet ist, dass jedes generierte Audiosignal mit der Frequenz, die die gleiche ist wie die jeweilige Bandsperrfrequenz, nur generiert wird, wenn das verzerrte Audiosignal (1) die jeweilige Frequenzkomponente bei der jeweiligen Bandpassfrequenz enthält.

## Revendications

1. Procédé de traitement d'un signal audio distordu (1) pour réparer la distorsion du signal audio distordu (1), le procédé consistant à :
faire passer le signal audio distordu (1) à travers un filtre à réjection de bande (14) pour délivrer un signal filtré par filtre à réjection de bande, le filtre à réjection de bande (14) ayant une fréquence de réjection de bande qui est telle que le signal filtré par filtre à réjection de bande ne contient aucune composante de fréquence à la fréquence de réjection de bande ;
faire passer le signal audio distordu (1) à travers un filtre passe-bande (12) pour délivrer un signal filtré par filtre passe-bande, la fréquence de passe-bande du filtre passe-bande (12) étant la même que la fréquence de réjection de bande du filtre à réjection de bande (14) ;
déterminer, au moyen d'un détecteur de signal (18), si le signal audio distordu (1) contient une composante de fréquence à la fréquence de passe-bande, en détectant la présence du signal filtré par filtre passe-bande tel que délivré par le filtre passe-bande (12) ; et
si le signal audio distordu (1) contient une composante de fréquence à la fréquence de passe-bande, générer, au moyen d'un générateur de signal (20), un signal audio généré ayant une fréquence qui est la même que la fréquence de réjection de bande, et ajouter, au moyen d'un sommateur (22), le signal audio généré au signal filtré par filtre à réjection de bande pour obtenir un signal audio réparé (2).

2. Procédé selon la revendication 1, consistant à recevoir une entrée d'utilisateur pour le niveau du signal audio généré à ajouter au signal filtré par filtre à réjection de bande, dans lequel le signal audio généré ajouté au signal filtré par filtre à réjection de bande est ajouté au niveau de l'entrée d'utilisateur pour obtenir le signal audio réparé (2).

3. Procédé selon la revendication 2, consistant à fournir une représentation graphique du signal audio distordu (1) avant qu'il ne soit réparé, et une représentation graphique du signal audio réparé (2), et à recevoir l'entrée d'utilisateur via une interface d'utilisateur graphique pour commander la réparation de la distorsion du signal audio (1).

4. Procédé selon l'une quelconque des revendications 1 à 3, consistant à :
détecter, au moyen du détecteur de signal (18), le niveau du signal filtré par filtre passe-bande tel que délivré par le filtre passe-bande (12).

5. Procédé selon l'une quelconque des revendications 1 à 4, dans lequel :
l'étape de faire passer le signal audio distordu (1) à travers le filtre à réjection de bande (14) consiste à faire passer le signal audio distordu (1) à travers plusieurs filtres à réjection de bande (14) pour délivrer le signal filtré par filtre à réjection de bande, chaque filtre à réjection de bande (14) ayant une fréquence de réjection de bande différente qui est telle que le signal filtré par filtre à réjection de bande ne contient aucune composante de fréquence aux fréquences de réjection de bande ;
l'étape de générer, au moyen du générateur de signal (20), le signal audio généré consiste à générer plusieurs signaux audio, chaque signal audio généré ayant une fréquence qui est la même qu'une fréquence respective parmi les fréquences de réjection de bande ; et
l'étape d'ajouter, au moyen du sommateur (22), le signal audio généré au signal filtré par filtre à réjection de bande consiste à ajouter lesdits plusieurs signaux audio générés au signal filtré par filtre à réjection de bande pour obtenir le signal audio réparé (2).

6. Procédé selon la revendication 5, lequel l'étape de faire passer le signal audio distordu (1) à travers le filtre passe-bande (12) consiste à faire passer le signal audio (1) à travers plusieurs filtres passe-bande (12) pour délivrer des signaux filtrés par filtre passe-bande correspondants, les fréquences de passe-bande des filtres passe-bande (12) étant respectivement les mêmes que les fréquences de réjection de bande des filtres à réjection de bande (14) ; et consiste à :
déterminer, au moyen du détecteur de signal (18), si le signal audio distordu (1) contient une composante de fréquence respective à chaque fréquence parmi les fréquences de passe-bande, en détectant la présence du signal filtré par filtre passe-bande respectif tel que délivré par le filtre passe-bande respectif (12) ;
dans lequel chaque signal audio généré ayant la fréquence qui est la même que la fréquence de réjection de bande respective n'est uniquement généré que si le signal audio distordu (1) contient la composante de fréquence respective à la fréquence de passe-bande respective.

7. Appareil (10) de traitement d'un signal audio distordu (1) pour réparer la distorsion du signal audio distordu (1), l'appareil (10) comprenant :
un filtre à réjection de bande (14) pour recevoir le signal audio distordu (1) et délivrer un signal filtré par filtre à réjection de bande, le filtre à réjection de bande (14) ayant une fréquence de réjection de bande qui est telle que le signal filtré par filtre à réjection de bande ne contient aucune composante de fréquence à la fréquence de réjection de bande ;
un filtre passe-bande (12) pour recevoir le signal audio distordu (1) et délivrer un signal filtré par filtre passe-bande, la fréquence de passe-bande du filtre passe-bande étant la même que la fréquence de réjection de bande du filtre à réjection de bande (14) ;
un détecteur de signal (18) pour déterminer si le signal audio distordu (1) contient une composante de fréquence à la fréquence de passe-bande, en détectant la présence du signal filtré par filtre passe-bande tel que délivré par le filtre passe-bande (12) ;
un générateur de signal (20) agencé de manière á générer un signal audio généré ayant une fréquence qui est la même que la fréquence de réjection de bande si le signal audio distordu (1) contient une composante de fréquence à la fréquence de passe-bande ; et
un sommateur (22) pour ajouter le signal audio généré au signal filtré par filtre à réjection de bande pour obtenir un signal audio réparé (2).

8. Appareil (10) selon la revendication 7, comprenant une interface pour recevoir une entrée d'utilisateur pour le niveau du signal audio généré à ajouter au signal filtré par filtre à réjection de bande, l'appareil (10) étant agencé de telle sorte que le signal audio généré ajouté au signal filtré par filtre à réjection de bande est ajouté au niveau de l'entrée d'utilisateur pour obtenir le signal audio réparé (2).

9. Appareil (10) selon la revendication 8, agencé de manière à délivrer, à des fins d'affichage, une représentation graphique du signal audio (1) avant qu'il ne soit réparé, et une représentation graphique du signal audio réparé (2), et agencé de manière à recevoir l'entrée d'utilisateur via une interface d'utilisateur graphique pour commander la réparation de la distorsion du signal audio (1).

10. Appareil (10) selon l'une quelconque des revendications 7 à 9, comprenant :
le détecteur de signal (18) étant agencé de manière à détecter le niveau du signal filtré par filtre passe-bande tel que délivré par le filtre passe-bande (12).

11. Appareil (10) selon l'une quelconque des revendications 7 à 10, comprenant :
plusieurs filtres à réjection de bande (14) pour recevoir le signal audio distordu (1), chaque filtre à réjection de bande (14) ayant une fréquence de réjection de bande différente qui est telle que le signal filtré par filtre à réjection de bande ne contient aucune composante de fréquence aux fréquences de réjection de bande ; et
plusieurs générateurs de signal (20) pour générer plusieurs signaux audio, chaque signal audio généré ayant une fréquence qui est la même qu'une fréquence respective parmi les fréquences de réjection de bande respectives ;
le sommateur (22) étant agencé de manière à ajouter lesdits plusieurs signaux audio générés au signal filtré par filtre à réjection de bande pour obtenir le signal audio réparé (2).

12. Appareil (10) selon la revendication 11, comprenant :
plusieurs filtres passe-bande (12) pour recevoir le signal audio distordu (1), les fréquences de passe-bande des filtres passe-bande (12) étant les mêmes que les fréquences de réjection de bande des filtres respectifs parmi les filtres à réjection de bande (14) pour délivrer des signaux filtrés par filtre passe-bande ; et
le détecteur de signal (18) étant agencé pour déterminer si le signal audio distordu (1) contient une composante de fréquence respective à chacune des fréquences de passe-bande, en détectant la présence du signal filtré par filtre passe-bande respectif tel que délivré par le filtre passe-bande respectif (12) ;
l'appareil (10) étant agencé de telle sorte que chaque signal audio généré ayant la fréquence qui est la même que la fréquence de réjection de bande respective n'est uniquement généré que si le signal audio distordu contient la composante de fréquence respective à la fréquence passe-bande respective.
